# FASCICULE DE BREVET EUROPEEN

(11) **EP 0 610 207 B1**
(45) Date de publication et mention de la délivrance du brevet: **30.09.1998**
(21) Numéro de dépôt: 92911464.3
(22) Date de dépôt: 15.05.1992
(51) Int. Cl.: H01L 21/00

(54) **PROCEDE ET DISPOSITIF DE TRAITEMENT ET DE NETTOYAGE DE PLAQUES A REACTEUR CENTRAL**
VERFAHREN UND VORRICHTUNG ZUR BEHANDLUNG UND REINIGUNG VON PLATTEN MIT EINEM ZENTRALEN REAKTOR
METHOD AND DEVICE FOR PROCESSING AND CLEANING WAFERS USING A CENTRAL REACTOR

(30) Priorité: 24.05.1991 FR 9106558
(43) Date de publication de la demande: 17.08.1994
(73) Titulaire: CYBERNETIX MICROELECTRONICS, 13013 Marseille (FR)
(72) Inventeur: MICHEL, Georges, L., F-13009 Marseille (FR); NATHAN, Olivier, F-13120 Gardanne (FR)
(74) Mandataire: Somnier, Jean-Louis
(86) Numéro de dépôt international: FR9200433
(87) Numéro de publication internationale: WO9221142

(56) Documents cités:
- EP-A- 0 292 090
- WO-A-81/02533
- US-A- 4 840 530
- PATENT ABSTRACTS OF JAPAN vol. 6, no. 99 (E-111)(977) 8 Juin 1982

## Description

La présente invention a pour objet des procédés et dispositifs de traitement et de nettoyage de plaques à réacteur central, telles que des pièces plates à géométrie régulière.

Le secteur technique de l'invention est la fabrication de machines et d'appareils de traitement de pièces par voie chimique.

Une des applications principales de l'invention est le traitement, en vue essentiellement de leur nettoyage, de plaques en forme de disques plats, de type supports semi-conducteurs utilisés pour la réalisation de circuits intégrés, mais d'autres applications sont possibles pour le traitement par exemple d'écrans plats en verre, comme ceux des moniteurs, des téléviseurs, ou des disques optiques, ou de disques durs utilisés dans l'informatique, ou de toute autre pièce en couche mince, tel que défini comme étant des pièces plates à géométrie régulière.

Le matériau constituant ces plaques peut être en céramique, silicium ou autre matière; celles-ci sont des tranches découpées très fines, qui sont ensuite enrobées, gravées et/ou nettoyées.

Ces différentes opérations doivent être réalisées avec la meilleure efficacité possible et dans un temps assez court pour, d'une part améliorer la fiabilité des plaques obtenues et, d'autre part, réduire le coût de production.

Dans la description ci-après, on définit essentiellement par référence à l'art antérieur, des procédés et appareils concernant le nettoyage de telles plaques semi-conductrices, mais il est clair que la présente invention, comme le précise les revendications, peut s'appliquer d'une part à toute autre pièce plate à géométrie régulière circulaire tels que des écrans plats, des filtres solaires, des disques optiques etc, et d'autre part, à d'autres traitements chimiques de ces mêmes pièces et qui ne soient pas uniquement de nettoyage.

On connaît en effet différents procédés et appareils pour le nettoyage de plaques qui sont manipulées et transférées d'un poste de travail à un autre dans des paniers-supports desquels elles sont extraits une par une ou par groupe pour être traitées dans chaque poste de travail.

En ce qui concerne les opérations de nettoyage, celles-ci sont très délicates, car il s'agit d'éliminer des particules de très petites dimensions consécutives par exemple, même en l'absence de pollution externe, à l'opération de gravure et qui ne doivent pas demeurer dans les sillons ainsi créés dans les plaques et qui sont eux-mêmes de très faible dimensions, car une seule de ces particules peut alors générer des contacts électriques parasites qui empêcheraient l'utilisation d'une partie de la plaque concernée et donc son élimination.

Le nettoyage est pour cela essentiel, critique et pratiqué en chambre propre étanche suivant trois types de méthodes :
- la méthode plaque à plaque, qui consiste à traiter successivement une plaque une par une dans des chambres de nettoyage placées côte à côte , ce qui constitue une opération lente nécessitant beaucoup de place et d'opérations de manutention;
- puis celle dite bac à bac, qui consiste à faire la même opération que précédemment, mais en déplaçant les plaques disposés par groupe dans des paniers, permettant ainsi une rapidité d'opération plus importante que dans la méthode précédente, mais nécessitant toujours autant de place pour les différents bacs de nettoyage;
- et enfin celle dite à réacteur central, dans laquelle se situe la présente invention et qui est privilégié à ce jour, car elle nécessite moins d'encombrement dans une chambre propre où la place est comptée et permet d'accélérer l'opération de séchage : au lieu en effet de déplacer les paniers de plaques comme dans la méthode précédente dans plusieurs bacs de nettoyage successifs comprenant des produits éventuels différents et qui prennent beaucoup de place, on enferme successivement chaque panier dans une chambre ou cuve, dans laquelle on projette sur les plaques, ou qu'on remplit jusqu'à immersion dudit panier, avec les produits de nettoyage ; et une fois les traitements effectués et les produits évacués du volume interne de la chambre , on sèche les plaques par centrifugation du panier.

Différents types d'appareils utilisant cette dernière méthode sont décrits dans les demandes de brevets EP 0 047 308 déposé sous priorité US le 27 Février 1981 et EP 0 292 090 déposé également sous priorité U.S. le 29 Février 1988 par la société SEMITOOL.

Dans ces appareils de type "machine à laver", comme dans d'autres utilisant le même principe de séchage par centrifugation, les plaques sont préalablement transférées de leur panier de transport dans un autre panier spécifique de ces appareils, permettant, d'une part d'immobiliser lesdites plaques pendant la centrifugation et, d'autre part, de transmettre le mouvement de rotation à celles-ci.

Cette méthode nécessite ainsi une double manutention pour le transfert des plaques de panier à panier, car celui de transport de poste à poste est lui aussi spécifique, et une mécanique de mise en oeuvre complexe, avec des problèmes d'équilibrage et d'inertie. De plus, le volume et l'encombrement de toutes ces pièces mécaniques masquent en partie les plaques à nettoyer, et l'homogénéité de nettoyage ne peut alors être assurée ni la répétabilité de la qualité de l'opération.

Le problème posé est donc de pouvoir réaliser des opérations de traitement et/ou de nettoyage de toutes pièces plates à géométrie régulière dans une chambre d'un appareil, dit à réacteur central, mais avec un minimum de pièces mécaniques intermédiaires, le moins possible d'opérations de manutention desdites pièces plates à traiter et/ou à nettoyer et une qualité optimum de répétabilité et d'homogénéité de traitement et/ou de nettoyage.

Une solution au problème posé est un dispositif de traitement de ces pièces plates à géométrie régulière, comprenant une chambre comportant des parois latérales, une paroi terminale, une ouverture dans une flasque avant en regard de ladite paroi terminale, un moyen support permettant de porter plusieurs pièces, un moyen d'introduction de fluides de traitements, un moyen de fermeture de ladite chambre, un moyen d'évacuation desdits fluides, de telle façon que l'on puisse traiter par ceux-ci lesdites pièces et vidanger ensuite la chambre; suivant l'invention, ledit moyen support des pièces est solidaire du moyen de fermeture et est constitué de deux peignes latéraux latéraux qui sont montés articulés sur des biellettes permettant, par basculement, leur écartement afin de permettre le passage desdites pièces entre les peignes, puis leur rapprochement, afin qu'ils prennent appui sous lesdites pièces et les maintiennent dans ladite chambre.

L'objectif de la présente invention est également atteint par un procédé de traitement de ces pièces utilisant le dispositif ci-dessus et comprenant les étapes suivantes :
- on amène lesdites pièces plates stockées dans leur panier de transport sous ladite chambre, que l'on ouvre en éloignant le caisson qui la constitue de son moyen de fermeture;
- on transfère par tout moyen de transfert lesdites pièces depuis le panier dans le volume ouvert de ladite chambre;
- on saisit ces pièces par basculement desdits deux peignes latéraux préalablement écartés et qui viennent prendre appui sous celles-ci, constituant alors leur dit moyen support, et on retire ledit moyen de transfert;
- on ferme ladite chambre en amenant ledit caisson autour desdites pièces et de leurs supports peignes, jusqu'au contact et étanchéité contre le moyen de fermeture;
- on effectue alors tout traitement par introduction de fluides dans la chambre et en fin de traitements et après évacuation des fluides, on retransfère lesdites pièces dans leur panier de transport.

De préférence, pour assurer une meilleure homogénéité des traitements sur la surface desdites pièces, surtout quand celles-ci sont de forme circulaire, on entraîne lesdits peignes latéraux supports en rotation, de telle façon que lesdites pièces plates tournent sur elles-mêmes à vitesse lente dans ladite chambre.

De plus, dans les traitements par projection de fluides et pour améliorer la diffusion de ceux-ci à la surface desdites pièces, on projette lesdits fluides par des rampes de nébulisation dont les orifices sont situés dans les plans séparant deux pièces contigues.

Dans un mode préférentiel de traitements pour effectuer un nettoyage et un séchage desdites pièces après tout traitement par fluides liquides, on remplit ladite chambre jusqu'à immersion complète des pièces d'un liquide chaud ayant un bon pouvoir absorbant de l'eau, et on évacue ledit fluide à une vitesse au plus égale à celle équilibrant les tensions de capillarité de ce liquide à la surface desdites pièces et permettant l'entraînement des particules à éliminer non adhérentes.

Le résultat est de nouveaux procédés et dispositifs de traitements de pièces plates à géométrie régulière, telles qu'en particulier les plaques semi-conductrices, qui peuvent alors être traitées puis nettoyées dans les meilleures conditions.

En effet, la particularité essentielle des procédés et des dispositifs suivant la présente invention est la suppression des paniers supports intermédiaires qui sont situés à ce jour à l'intérieur des machines de traitement, constituent un volume mort, masquent les pièces ou plaques à traiter, font obstacle à la bonne circulation des fluides et sont eux-mêmes des éléments les plus difficiles à traiter.

Dans la présente invention, il n'y a plus de paniers supports à l'intérieur de la machine, puisque les plaques ou pièces sont maintenues uniquement par deux peignes latéraux qui s'effacent pour le transfert de ces plaques vers ou de l'intérieur du caisson de traitement.

Ainsi, grâce à la réduction importante du système support de maintien des plaques dans le caisson, le volume de la chambre proprement dit peut être réduit dans une proportion importante : à l'heure actuelle les volumes de chambres sont de l'ordre au minimum de 30 litres, alors que dans les procédés et les dispositifs de la présente invention, le volume de la chambre peut être réduit à une quinzaine de litres environ.

De plus, l'absence de volume mort important autour des pièces à traiter ou à nettoyer, permet une meilleure homogénéité de ce nettoyage ou de ce traitement, ainsi qu'une plus grande possibilité de répétabilité et de qualité du résultat obtenu.

Le panier support de traitement utilisé dans les systèmes actuels est lui-même une source de contamination puisqu'il est constitué d'un certain nombre de pièces pouvant elles-mêmes piéger des particules de pollution, qui une fois dans la chambre lors du traitement, peuvent venir polluer les pièces à nettoyer.

Dans la présente invention, il n'est pas utilisé non plus de système de séchage par centrifugation de façon à supprimer, en plus du panier support, les différentes pièces mécaniques qui allourdissent et compliquent les systèmes actuels, et augmentent les forces d'inertie et les problèmes d'équilibrage. Cependant, on peut favoriser d'une part, une meilleure répartition des fluides de traitements, et donc l'homogénéité de ceux-ci, par rotation lente, des pièces quand celles-ci sont en particulier des disques.

On assure le séchage par des liquides chauds vidangés à vitesse lente, entraînant ainsi les particules à évacuer, ce qui est possible du fait de la réduction du volume indiqué ci-dessus de la chambre, alors que dans les chambres à volume important, ce type de séchage serait très lent et beaucoup plus coûteux; celui-ci est cependant connu dans d'autres procédés, mais non utilisés à ce jour dans les applications envisagées de la présente invention.

De même et de plus, la chambre, ou le caisson, rendu étanche et du fait de sa position horizontale peut être remplie d'atmosphère neutre tel que de l'azote, entre les différentes étapes de traitements, ledit gaz permettant alors de pousser le fluide après chaque opération afin d'accélérer sa vidange et faciliter le procédé de séchage tel que défini ci-dessus.

Un autre avantage des dispositifs et des procédés suivant l'invention est que, lorsqu'on introduit des fluides liquides dans ladite chambre jusqu'à immerger complètement lesdites pièces à traiter, on peut alors effectuer au moins un traitement par vibrations sonores de celles-ci, tel que par traitement ultrasonore ou essentiellement mégasonique, favorisant le nettoyage et la gravure.

Ceci est d'autant plus possible grâce également au petit volume de liquide contenu dans la chambre.

L'appareil ou la machine incluant les dispositifs réalisés suivant la présente invention peut être ainsi qualifié de machine multiprocédé, permettant différents types de traitement, qui vont au delà du seul nettoyage, telles que sont pourtant souvent spécialisées à ce jour les machines à réacteur central.

Les machines telles que décrites ci-dessus permettent d'envisager des traitements tels qu'indiqués précédemment, mais également d'autres traitements non décrits dans la présente invention.

Un autre avantage de la réduction du volume de la chambre est de réduire également l'encombrement de la machine complètement terminée, qui au sol, peut occuper alors une surface seulement de l'ordre de 700 mm sur 700 mm, ce qui est intéressant dans une salle blanche, dont la place disponible est un des problèmes définis précédemment.

De plus, sa capacité de multiprocédé permet de l'intégrer dans une chaîne avec d'autres postes de traitement, ou à l'intérieur d'une unité traditionnelle en l'adaptant suivant le procédé envisagé.

De même, on peut envisager la juxtaposition de plusieurs appareils côte à côte ou l'un au-dessus de l'autre afin de réaliser un ou plusieurs procédés de traitement, avec des quantités variables de fluides de traitement, et/ou de pièces à traiter, et avec un ou plusieurs systèmes de transfert et de chargement.

Enfin, un autre avantage à souligner et indiqué dans le problème posé, est la suppression de deux opérations de manutention, puisqu'il n'y a plus transfert de plaques de panier à panier avant et après le traitement, les plaques ou pièces à traiter étant directement amenées dans la chambre par tout moyen de transfert, pour être posées sur les peignes situés à l'intérieur de la chambre et réciproquement en fin de traitement.

On pourrait citer d'autres avantages de la présente invention, mais ceux cités ci-dessus en montrent déjà suffisamment pour en démontrer la nouveauté et l'intérêt.

La description et les figures ci-après représentent un exemple de réalisation de l'invention, mais n'ont aucun caractère limitatif : d'autres réalisations sont possibles à partir des revendications qui précisent la portée et l'étendue de cette invention, en particulier en changeant la forme de base des différentes pièces constituant le caisson, ainsi qu'en changeant, d'une part, les traitements possibles des pièces à nettoyer et, d'autre part, la forme proprement dite des pièces elles-mêmes, celles-ci pouvant être de toute nature.

La figure 1 est une vue perspective d'un dispositif de traitement.

La figure 2 est une vue en coupe longitudinale de ce dispositif.

La figure 3 est une vue en coupe transversale de la chambre du dispositif.

La figure 4 est une vue en coupe transversale du capot avant du dispositif.

Le dispositif de traitement, suivant la présente invention, pour des pièces plates 11 à géométrie régulière, représentées ici à titre d'exemple comme étant circulaires, utilise d'une manière connue comme dans d'autres dispositifs existant à ce jour, une chambre 28, comportant des parois latérales, ici représentée sous forme d'un caisson cylindrique 7, une paroi terminale 9 ou flasque arrière, une ouverture dans une flasque avant 8 en regard de ladite paroi terminale 9, un moyen support permettant de porter plusieurs pièces 11, situées à l'intérieur de ladite chambre 28 pendant le traitement, un moyen 15 d'introduction de fluides de traitements, un moyen 6 de fermeture de ladite chambre 28, constituée ici par un couvercle 6 supportant un capot 3, un moyen d'évacuation 14 desdits fluides, de telle façon que l'on puisse traiter par ceux-ci lesdites pièces une fois introduites à l'intérieur de la chambre et vidanger ensuite celle-ci.

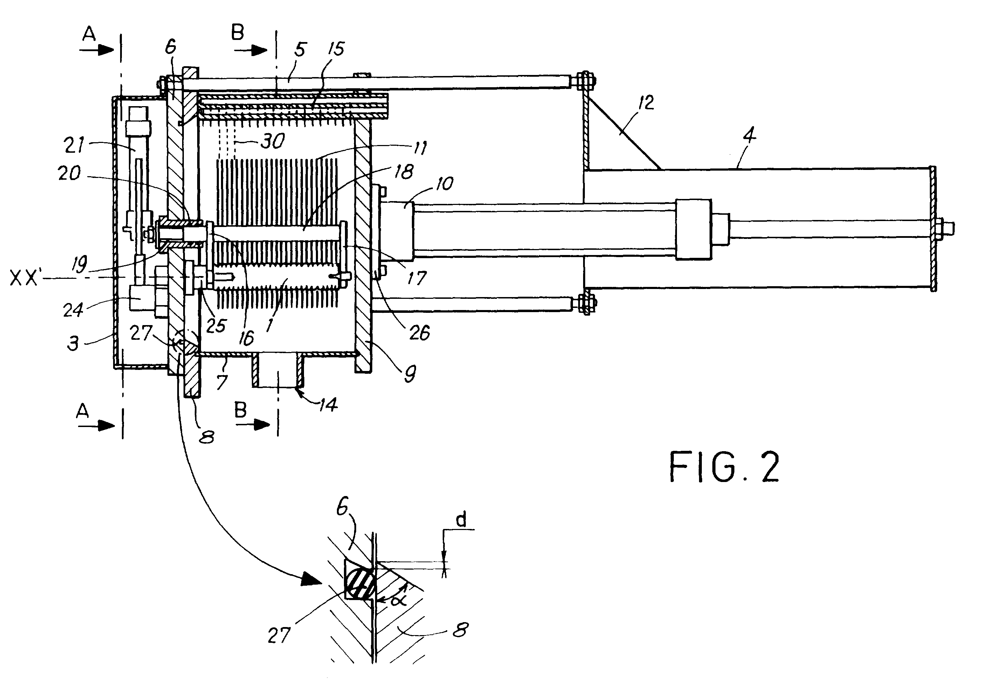

Contrairement au dispositif actuel dans lequel on introduit lesdites pièces 11, préalablement transférées dans un panier spécifique suivant l'axe de ladite chambre 28, par ouverture et dégagement complet du système de fermeture du couvercle 6, dans la présente invention, on ouvre ladite chambre 28 en éloignant simplement dans l'axe le caisson 7, qui la constitue, du moyen de fermeture 6, de façon à dégager le volume utile pour une introduction desdites pièces 11 par en-dessous dudit volume. Pour cela, le couvercle 6 et son capot avant 3 sont considérés fixes, et c'est le caisson 17 avec ses deux flasques avant 8 et arrière 9, qui est déplacé grâce à des dispositifs tels que définis dans la figure 2 et le long de barres de guidage 5. Lesdites pièces plates 11 sont stockées préalablement d'une manière connue dans un panier de transport 2 qui est amené en-dessous de ladite chambre 28; celle-ci étant ouverte, on transfère par tout moyen 29 lesdites pièces 11 de ce panier 2 dans le volume ouvert de ladite chambre 28, sans nécessiter de panier spécifique au traitement dans cette chambre.

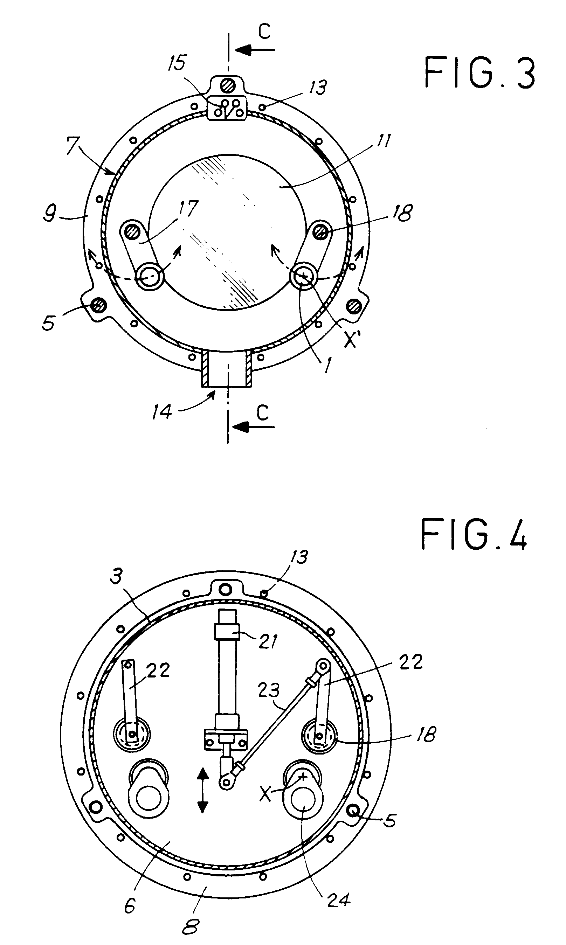

En effet, dans la présente invention ledit moyen support de pièces 11 est nécessaire au maintien des pièces dans la chambre, n'est pas mobile par rapport à celle-ci, mais est solidaire du moyen 6 de fermeture, et est constitué de deux peignes 1 latéraux qui sont montés articulés sur des biellettes 16/17, telles que représentées sur la figure 3 et permettant par basculement leur écartement, afin de permettre le passage desdites pièces 11 entre ces peignes, puis leur rapprochement, afin qu'ils prennent appui sous celles-ci et les maintenir dans ladite chambre 28 pour subir lesdits traitements désirés et choisis.

Dans un mode préférentiel de réalisation, et cela surtout par des pièces plates 11 de forme circulaire, tel que représenté dans les exemples de figures, mais cela peut être envisagé par des formes non circulaires, lesdits peignes 1 latéraux sont montés sur des axes pouvant être entraînés en rotation, tel que par exemple par des aimants solidaires de l'axe de ces peignes et grâce à un système d'entraînement extérieur tel que défini dans les figures 2 et 4.

En ce qui concerne la réalisation du caisson 7, celui-ci peut être constitué comme dit précédemment par des parois latérales en forme de cylindre relié à chacune de ses extrémités à des flasques avant 8 et arrière 9, cette dernière est fermée alors que la flasque avant est ouverte, de façon à venir lors du déplacement de la chambre, coiffe l'ensemble des pièces posées sur les peignes 1.

Les deux flasques 8 et 9 peuvent être reliées par des tirants 15, qui en assurent la rigidité et le maintien, tout en assurant la tenue en pression dudit caisson 7, quand ladite chambre 28 est mise sous pression.

En ce qui concerne le système de déplacement dudit caisson tel que défini dans la figure 2, il peut être recouvert par une structure ou capot arrière 4, qui est relié au système de guidage 5 par une flasque et des goussets 12 qui assurent la rigidité, constitue alors par le capot avant 3 et son couvercle 6, les barres de guidage 5 et le capot arrière 4, un ensemble mécanique rigide et solidaire : d'autres moyens de translation sans capot arrière 4 et éventuellement moins rigides, peuvent être utilisés surtout quand on sépare la fonction de verrouillage, pour l'étanchéité du moyen de fermeture contre le caisson, de celle de translation de celui-ci contre ce dit moyen de fermeture.

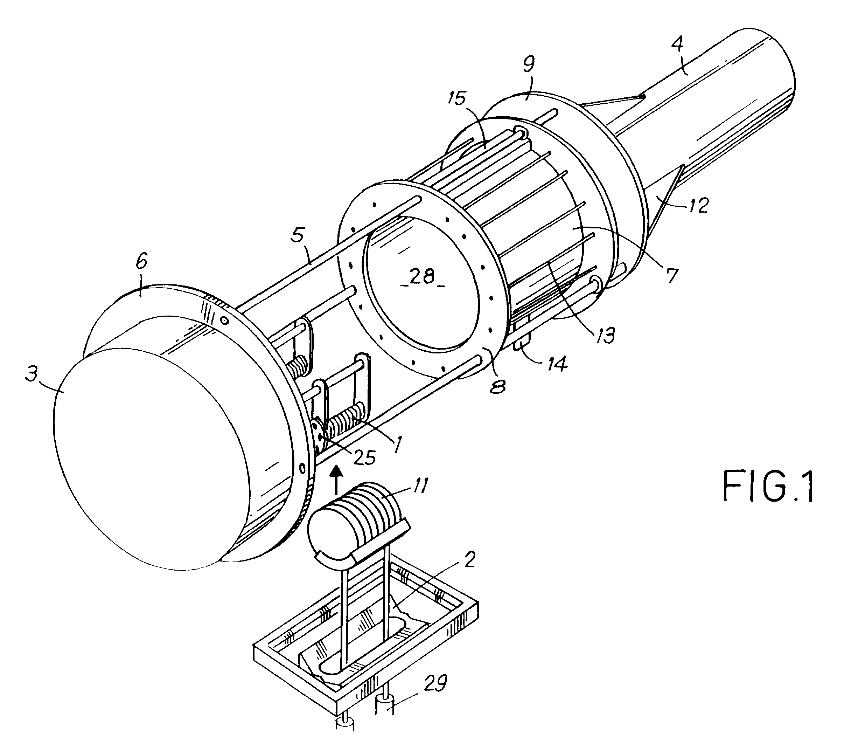

La figure 2 est une vue en coupe de ce même dispositif tel que décrit dans la figure 1, longitudinalement suivant un plan vertical découpant cependant le dispositif suivant les axes des peignes et de leur axe support, de façon à rendre plus compréhensible la description.

Alors que la figure 1 représente le caisson 7 en position ouverte pour dégager la chambre 28 afin d'y insérer les pièces ou plaques 11 à traiter ou à nettoyer, dans cette figure 2, la chambre 28 est représentée fermée par translation du caisson 7 jusqu'à ce que sa flasque avant 8 vienne prendre appui contre le couvercle 6 et assurer l'étanchéité; celle-ci peut être réalisée soit directement par un appui suffisant assuré par le système de translation tel que défini ci-après, soit par tout moyen indépendant de celui-ci assurant une fonction de verrouillage étanche, après translation et appui dudit caisson contre ledit moyen de fermeture. Cette fonction de verrouillage peut être assurée par des doigts, un clamp tournant, ou autre dispositif connu utilisé chaque fois que l'on veut réaliser une enceinte étanche, résistant à un minimum de pression. Ceci permet, non seulement d'assurer une meilleure étanchéité et donc une meilleure sécurité, mais également d'alléger le système de translation du caisson lui-même.

La translation du caisson 7 peut être effectuée par un vérin 10, dont une extrémité est solidaire du capot arrière 4, dans le cas où l'on désire avoir non seulement un système de translation, mais également un système permettant un appui suffisamment étanche contre le moyen de fermeture, et donc également, par les goussets 12 et les barres de guidage 5, du couvercle 6, et dont l'autre extrémité est solidaire de la flasque arrière ou paroi terminale du caisson 7 grâce par exemple à une flasque 26 d'appui contre cette dite flasque arrière. Ce vérin 10 peut permettre ainsi, en plus de sa fonction d'ouverture et de fermeture, d'assurer l'étanchéité de la chambre 28 en appuyant la flasque avant 8 contre le couvercle 6 et, grâce à un joint d'étanchéité 27 tel que représenté par exemple en détail dans la figure 2 dans le rond de renvoi.

Ainsi, le moyen de fermeture 6 de ladite chambre 28 est en appui étanche grâce à ce vérin 10, ou grâce à tout autre moyen de verrouillage assurant ladite étanchéité du caisson 7 contre ledit moyen de fermeture 6, indépendamment de celui assurant la translation du caisson contre la flasque avant 8 : par écrasement de ce joint 27, qui peut supporter une force par exemple de l'ordre de 100 kg, il est possible alors de mettre ladite chambre en dépression jusqu'au vide même ou en surpression, et ainsi assurer les différents types de traitement tels qu'indiqués précédemment et précisés ci-après.

Ledit joint 27 peut être un joint torique situé dans une gorge creusée dans le moyen de fermeture 6 et dont le bord interne est déterminé à une distance "d" la plus faible possible, compatible avec les tolérances des jeux mécaniques dudit dispositif, du bord interne de l'ouverture de la flasque avant 8, celle-ci étant découpée en cône suivant un angle a divergent vers l'intérieur de la chambre 28. De préférence, cet angle a est de l'ordre de 30°; il évite la rétention de produits et ainsi permet un meilleur nettoyage de la chambre en économisant alors les produits de rinçage et de traitement.

La distance "d" séparant les différents bords précisés ci-dessus doit être effectivement minimisée de façon à éviter de piéger de particules de pollution qui pourraient perturber le traitement.

Le joint 27 peut être également situé, dans d'autres modes de réalisation, dans une gorge creusée dans la flasque 8 du caisson 7.

L'intérêt de cette étanchéité outre le fait qu'elle est nécessaire, mais à un degré minimum du fait de la position horizontale ou sensiblement horizontale de ladite chambre pour éviter les fuites de liquides, permet de remplir la chambre également de gaz neutre de type azote, entre les différentes étapes de traitements, et même de pressuriser ce gaz; cette pressurisation peut aider la chasse du fluide par l'évacuation 14, en poussant sur celui-ci, facilite aussi le séchage des plaques à nettoyer et permet de ventiler également la chambre entre deux passages de fluide et de traitement.

Ces dits fluides sont amenés par une rampe 15 qui peut être d'atomisation ou de nébulisation, de façon à projeter ledit fluide sur lesdites pièces à traiter.

Ce principe et ce dispositif de projection de fluides sont connus dans d'autres machines de traitement, mais dans la présente invention, de préférence, et cela est rendu possible grâce à la fixation solidaire desdits peignes 1 qui maintiennent alors lesdites pièces à nettoyer dans des positions précises connues par rapport au couvercle 6, et donc à l'ensemble du caisson et de la chambre 28 : il est ainsi possible de déterminer des positions de jets de la rampe 15 dans l'axe des espaces interplaques, de telle sorte que les orifices de ladite rampe sont situés dans des plans séparant deux pièces ou plaques 11 contiguës. Ainsi, dans un mode de réalisation où ces espaces interplaques sont de l'ordre de 2,54 mm, les jets 30 peuvent être dirigés exactement dans ces espaces et permettent une meilleure homogénéité de projection et d'atomisation des fluides de traitement, ce qui n'est pas possible dans les systèmes actuels où le panier support, étant transféré à l'intérieur de la chambre, ne permet pas une telle précision.

Par ailleurs, en plus de ces jets 30 dirigés vers les interespaces entre lesdites plaques, ladite rampe ou d'autres rampes 15 peuvent projeter des jets contre les parois circulaires intérieures du caisson, afin d'en assurer le rinçage et ainsi de dépolluer au mieux en permanence l'intérieur de ladite chambre 28.

On remarque sur cette figure 2 le faible encombrement de cette chambre par rapport à la taille des plaques des pièces 11 à traiter, du fait des dispositifs spécifiques de la présente invention dont, en particulier, la disposition des peignes supports 1, suspendus à des axes de pivotement grâce à des biellettes 16 avant et 17 arrière, à celles-ci assurent le basculement de ces peignes 1, afin d'une part de dégager l'espace inférieur pour introduire lesdites pièces dans la chambre et, d'autre part, par leur basculement vers l'intérieur de celle-ci de supporter ces dites pièces telles que définies précédemment et indiquées en coupe BB sur la figure 3.

La rotation de ces axes support peignes 18 peut être assurée pour chacun, à travers le couvercle 6, grâce à un palier 19 ou passage de coque, assurant l'étanchéité grâce à un joint torique 20 autour de cet axe 18, de façon à absorber les dépressions ou surpressions que l'on provoque à l'intérieur de la chambre.

Cet axe 18 peut être alors ensuite entraîné en rotation de l'angle nécessaire grâce à un système de biellettes tel que défini en coupe AA sur la figure 4 et relié à un vérin linéaire 21. L'étanchéité sur cet axe 18 est assez simple à réaliser puisque le mouvement de rotation de cet axe est au maximum d'un quart de tour et ne nécessite donc pas de précision d'étanchéité, comme peut l'être un axe qui tourne en continu et à grande vitesse, comme pour les machines centrifuges actuelles, dont les joints utilisés sont très chers et constituent une source de contamination.

En ce qui concerne la possibilité de rotation lente des peignes 1, essentiellement pour le traitement de pièces plates 11 circulaires celle-ci peut être effectuée grâce à des aimants solidaires de l'extrémité des axes peignes 25, ne traversant pas le couvercle 6 : le moyen d'entraînement de chacun desdits peignes 1 peut être en effet constitué d'un moto réducteur 24 externe à ladite chambre solidaire d'un accouplement magnétique placé contre ledit moyen de fermeture 6 et entraînant au travers de celui-ci une platine support des aimants 25, fixée à l'extrémité et dans l'axe dudit peigne 1 quand celui-ci et en position basculée permettant le maintien desdites pièces 11, telles que représentées dans la figure 4.

Cet entraînement magnétique est possible, puisqu'il suffit d'une rotation lente sans effort important, quand les pièces sont circulaires, cette rotation étant juste utile et intéressante pour assurer une homogénéité de traitement des pièces à l'intérieur de ladite chambre 28, donc sans vitesse rapide : ce système d'entraînement ne nécessite alors pas de traversée de cloison et permet de simplifier la réalisation mécanique et l'étanchéité de la chambre 28.

L'ensemble de ces systèmes d'entraînement, comme le moto réducteur 24 et le vérin 21, peut être enfermé alors un capot de protection avant 3, qui n'a pas de fonction directe dans le présent dispositif suivant l'invention.

la figure 3 représente en coupe BB, référencée sur la figure 2, l'intérieur de la chambre 28 au niveau des peignes supports 1 en position d'appui sous les pièces à traiter 11, après basculement autour des axes 18 supports.

On retrouve sur cette figure différents autres éléments du caisson 7, que sont les tirants 13 reliant les flasques avant 8 et arrière 9, ainsi que les barres de guidage 5 reliant le couvercle 6 avec le système d'entraînement du caisson tel que décrit précédemment.

On repère également sur cette figure la rampe d'atomisation 15, ainsi que la bouche d'évacuation 14 qui peut être reliée à tout système étanche pour récupérer les fluides une fois les traitements effectués.

Sur cette figure 3 est représenté en pointillé le mouvement de basculement des peignes 1 suivant un cercle décrit par leur axe x', de rayon égal à la longueur des biellettes 17 et suivant un angle qui peut être au maximum vers l'extérieur celui permettant d'écarter lesdits peignes 1 à la verticale des axes 18 et dans le sens intérieur d'appui sous les pièces 11, cet angle est fonction des diamètres de cesdites pièces de façon à les centrer au mieux dans ladite chambre.

La figure 4 est une coupe AA référencée sur la figure 2, du capot 3 situé sur le couvercle 6. On retrouve sur cette figure différents éléments correspondant au caisson se situant derrière ce couvercle 6, c'est-à-dire les tirants 13 dudit caisson ainsi que sa flasque avant 8. On relève également les extrémités des tiges de guidage 5 qui maintiennent ledit couvercle 6 en position par rapport à la partie arrière dudit dispositif tel que décrit précédemment.

La face visible alors dudit couvercle permet d'apercevoir les seules traversées de cloisons de la chambre de traitement que sont les extrémités des axes 18 des supports de peignes : ces extrémités sont solidaires de biellettes 22 reliées par des tiges de liaison 23 à l'extrémité d'un vérin 21 situé par exemple dans l'axe dudit couvercle, et pouvant entraîner les deux biellettes 22 des deux axes 18 support de peignes, de façon à assurer le mouvement de rotation et de basculement tel que décrit dans la figure 3 précédente.

D'autres systèmes d'entraînement de ces dits axes 18 peuvent être également envisagés.

Sur cette coupe AA figure également les moto réducteurs 24 pour l'entraînement magnétique des aimants 25 solidaires des axes des peignes 1 quand ceux-ci se trouvent dans le même axe X que celui d'entraînement desdits moto réducteurs : dans ce système la position des axes X et X' confondus est donc uniques, et correspond à un seul diamètre desdites pièces 11; mais il peut être envisagé, suivant différents types de diamètre de pièces 11 à traiter, de déplacer alors les moto réducteurs 24 dans différentes positions, sans que cela nécessite de percer ledit couvercle, puisque l'entraînement se fait à travers lui.

Comme défini dans les différents procédés de traitement décrits précédemment et pouvant être réalisés dans les appareils ou machines suivant la présente invention, et que l'on peut qualifier de machines multi procédés à chambre ouverte, il n'est pas possible de réaliser dans celles-ci de centrifugation pour effectuer un séchage tel que dans les machines actuelles. Du fait de la petite taille de cette chambre et de l'absence de panier support le procédé de séchage est cependant tel qu'après tout traitement par fluides liquides desdites pièces 11, on peut remplir ladite chambre 28 jusqu'à immersion complète des pièces 11 d'un liquide chaud qui est, de préférence, de l'eau désionéisée environ à 65° ou de l'alcool pouvant absorber de l'eau à une température de l'ordre de 80°, et on évacue alors ledit liquide à une vitesse au plus égale à celle équilibrant les tensions de capillarité de ce liquide à la surface desdites pièces, tel que nous l'avons déjà décrit précédemment, et permettant l'entraînement des particules à nettoyer non adhérentes. Ceci peut être amélioré en poussant lesdits liquides par un gaz neutre tel que de l'azote, ce qui permet d'accélérer l'opération et donc d'obtenir une durée de traitement réduite.

On peut compléter cette opération de séchage en réalisant le vide à l'intérieur de ladite chambre tel qu'en branchant une pompe à vide à l'évacuation 14.

De plus, on peut avant cette opération de vide, balayer par un gaz neutre sec de type azote l'ensemble de la chambre afin d'évacuer les dernières particules de pollution et/ou de liquide, qui resteraient accrochées auxdites pièces ou à la paroi de la chambre.

Une combinaison des différentes opérations ci-dessus peut permettre d'obtenir un séchage optimum.

## Revendications

1. Dispositif de traitements de pièces plates (11) à géométrie régulière comprenant une chambre (28) comportant des parois latérales, une paroi terminale (9), une ouverture dans une flasque avant (8) en regard de ladite paroi terminale, un moyen support permettant de porter plusieurs pièces (11), un moyen (15) d'introduction de fluides de traitements, un moyen (6) de fermeture de ladite chambre (28), un moyen d'évacuation (14) desdits fluides, de telle façon que l'on puisse traiter par ceux-ci lesdites pièces (11) et vidanger ensuite la chambre (28), caractérisé en ce que ledit moyen support des pièces (11) est solidaire du moyen (6) de fermeture et est constitué de deux peignes (1) latéraux qui sont montés articulés sur des biellettes (16, 17) permettant, par basculement, leur écartement afin de permettre le passage desdites pièces (11) entre les peignes, puis leur rapprochement, afin qu'ils prennent appui sous lesdites pièces et les maintiennent dans ladite chambre.

2. Dispositif de traitements des pièces plates (11) suivant la revendication 1, caractérisé en ce que lesdits peignes (1) latéraux sont prévus pour être entraînés en rotation.

3. Dispositif de traitements suivant la revendication 2, caractérisé en ce que le moyen d'entraînement de chacun desdits peignes (1) est constitué d'un moteur réducteur (24) externe à ladite chambre, solidaire d'un accouplement magnétique placé contre ledit moyen de fermeture (6) et entraînant au travers de celui-ci une platine suportant des aimants (25) fixée à l'extrémité et dans l'axe dudit peigne (1) quand celui-ci est en position basculée pour le maintien desdites pièces (11).

4. Dispositif de traitements suivant l'une quelconque des revendications 1 à 3, caractérisé en ce que le moyen de fermeture (6) de ladite chambre (28) est en appui étanche contre la flasque avant (8) grâce à l'écrasement d'un joint (27) permettant de mettre ladite chambre en dépression ou en surpression.

5. Procédé de traitements de pièces plates (11) à géométrie régulière, utilisant le dispositif selon la revendication 1, et comportant les étapes suivantes :
- on amène lesdites pièces plates (11) stockées dans leur panier de transport (2) sous ladite chambre (28), que l'on ouvre en éloignant le caisson (7) qui la constitue de son moyen de fermeture (6);
- on transfère par tout moyen de transfert (29) lesdites pièces (11) depuis le panier (2) dans le volume ouvert de ladite chambre (28);
- on saisit ces pièces par basculement desdits deux peignes (1) latéraux préalablement écartés et qui viennent prendre appui sous celles-ci constituant alors leur dit moyen support, et on retire ledit moyen (29) de transfert;
- on ferme ladite chambre (28) en amenant ledit caisson (7) autour desdites pièces (11) et de leurs supports peignes (1), jusqu'au contact contre le moyen de fermeture (6) et on rend cet ensemble étanche;
- on effectue tout traitement par introduction de fluides dans la chambre grâce au moyen (15) et en fin de traitements et après évacuation des fluides par le moyen (14) et réouverture de celle-ci, on retransfère lesdites pièces (11) dans leur panier (2) de transport.

6. Procédé de traitements de pièces plates (11) à géométrie régulière, suivant la revendication 5, caractérisé en ce qu'on assure l'étanchéité du caisson (7) contre ledit moyen de fermeture (6) par tout moyen indépendant de celui-ci assurant la fermeture de ladite chambre (28) par translation dudit caisson contre ledit moyen de fermeture.

7. Procédé de traitements suivant l'une quelconque des revendications 5 et 6 et pour des pièces plates (11) de forme circulaire, caractérisé en ce que pendant lesdits traitements par fluides, on entraîne lesdits peignes (1) latéraux supports en rotation, de telle façon que lesdites pièces plates (11) tournent sur elles-mêmes à vitesse lente dans ladite chambre (28).

8. Procédé de traitements suivant l'une quelconque des revendications 5 à 7, caractérisé en ce qu'on projette lesdits fluides par des rampes (15) de nébulisation dont les orifices sont situés dans les plans séparant deux pièces (11) contigues.

9. Procédé de traitement suivant l'une quelconque des revendications 5 à 8, caractérisé en ce qu'on introduit lesdits fluides liquides dans la chambre (28) jusqu'à immerger complètement des pièces (11), permettant d'effectuer alors au moins un traitement par vibrations sonores de celles-ci.

10. Procédé de traitement suivant l'une quelconque des revendications 5 à 9, caractérisé en ce qu'après tout traitement par fluides liquides desdites pièces (11), on remplit ladite chambre (28) jusqu'à immersion complète des pièces (11), d'un liquide chaud ayant un bon pouvoir absorbant de l'eau, et on évacue ledit fluide à une vitesse au plus égale à celle équilibrant les tensions de capillarité de ce liquide à la surface desdites pièces et permettant l'entraînement des particules à éliminer non adhérentes.

## Patentansprüche

1. Bearbeitungsvorrichtung von flachen regelmäßigen Teilen (11) mit einer Seitenwände aufweisenden Kammer (28), einer Endwand (9), einer Öffnung in einem Vorderflansch (8), die gegenüber der Endwand angeordnet ist, einer Trägereinrichtung, die es ermöglicht mehrere Teile (11) zu tragen, einer Einleitungseinrichtung (15) für Bearbeitungsflüssigkeit, einer Schließvorrichtung (6) der Kammer (28) und einer Flüssigkeitsentleereinrichtung (14), wobei die Teile (11) durch diese behandelt werden können und danach die Kammer (28) geleert werden kann, dadurch gekennzeichnet, daß die Trägereinrichtung für Teile (11) mit der Schließeinrichtung (6) verbunden ist und aus zwei Seitenkämmen (1) gebildet wird, die auf Schwingarmen (16, 17) schwenkbar montiert sind, wobei ermöglicht wird, daß sich die Kämme durch das Schwenken entfernen, so daß ein Durchgang zwischen den Kämmen für die Teile (11) frei wird, und daß die Kämme dann zusammengeführt werden, so daß diese unter den Teilen zum Anliegen kommen und diese Teile in der Kammer festhalten.

2. Bearbeitungsvorrichtung von flachen Teilen (11) nach Anspruch 1, dadurch gekennzeichnet, daß die Seitenkämme gedreht werden können.

3. Bearbeitungsvorrichtung nach Anspruch 2, dadurch gekennzeichnet, daß die Antriebsvorrichtung von jedem Kamm (1) durch einen außen an der Kammer angeordneten Getriebemotor (24) gebildet wird und mit einer Magnetkupplung verbunden ist, die an der Schließeinrichtung (6) angeordnet ist und durch diese eine Platte mit Magneten (25) angetrieben wird, die an dem Ende und in der Achse des Kammes (1) befestigt sind, wenn dieser Kamm in Festhalteposition der Teile (11) geschwenkt ist.

4. Bearbeitungsvorrichtung nach Anspruch 1 bis 3, dadurch gekennzeichnet, daß durch das Zusammendrücken einer Dichtung (27) die Schließeinrichtung (6) der Kammer (28) im dichten Anschlag mit dem Vorderflansch (8) steht, wobei damit ermöglicht wird, in der Kammer einen Unterdruck oder Überdruck zu erzeugen.

5. Bearbeitungsverfahren von flachen regelmäßigen Teilen (11), das die Vorrichtung nach Anspruch 1 verwendet und die folgenden Arbeitsschritte umfaßt:
- die in ihrem Transportkorb (2) gelagerten flachen Teile (11) werden unter die Kammer (28) gebracht, wobei diese Kammer geöffnet wird, indem der Behälter (7) entfernt wird, der die Schließeinrichtung (6) der Kammer bildet;
- die Teile (11) werden vom Korb (2) aus in den geöffneten Raum der Kammer (28) durch alle möglichen Transfereinrichtungen (29) gebracht;
- diese Teile werden aufgenommen, indem die zuvor getrennten Seitenkämme (1) geschwenkt werden, und kommen unterhalb dieser zum Anliegen, wobei die Kämme somit die Trägereinrichtung der Teile bilden, und die Transfereinrichtung (29) wird entfernt;
- die Kammer (28) wird verschlossen, indem der Behälter (7) um diese Teile (11) und deren Tragekämme (1) geführt wird, bis er in Kontakt mit der Schließeinrichtung (6) gelangt und das Gesamte wird abgedichtet;
- jegliches Bearbeiten wird durch Einleiten von Flüssigkeit in die Kammer über die Einrichtung (15) durchgeführt und nach dem Bearbeiten und nach dem Entleeren der Flüssigkeit durch die Einrichtung (14) und nach dem Wiederöffnen der Kammer werden die Teile (11) in ihrem Transportkorb (2) zurücktransferiert.

6. Bearbeitungsverfahren von flachen regelmäßigen Teilen (11) nach Anspruch 5, dadurch gekennzeichnet, daß die Dichtigkeit zwischen dem Behälter (7) und der Schließeinrichtung (6) durch eine Einrichtung gewährleistet wird, die von der Schließeinrichtung getrennt ist, wobei der Verschluß der Kammer (28) gewährleistet wird durch Verschieben des Behälters auf die Verschließeinrichtung.

7. Bearbeitungsverfahren nach dem Anspruch 5 oder 6 für flache kreisförmige Teile (11), dadurch gekennzeichnet, daß während dem Bearbeiten mit den Flüssigkeiten die seitlichen Tragekämme (1) rotierend angetrieben werden, so daß sich die flachen Teile (11) in der Kammer (28) langsam um sich selbst drehen.

8. Bearbeitungsverfahren nach den Ansprüchen 5 bis 7, dadurch gekennzeichnet, daß die Flüssigkeiten durch Vernebelungsrampen (15) eingespritzt werden, wobei die Öffnungen in den Ebenen angeordnet sind, die zwei nebeneinanderliegende Teile (11) trennen.

9. Bearbeitungsverfahren nach den Ansprüchen 5 bis 8, dadurch gekennzeichnet, daß die Flüssigkeit in die Kammer (28) eingeleitet wird bis die Teile (11) komplett eingetaucht sind, damit an diesen mindestens eine Vibrations-Schallbehandlung durchgeführt werden kann.

10. Bearbeitungsverfahren nach den Ansprüchen 5 bis 9, dadurch gekennzeichnet, daß, nach allen Bearbeitungsmethoden der Teile (11) durch die Flüssigkeiten, die Kammer (28) mit einer warmen Flüssigkeit aufgefüllt wird bis die Teile (11) komplett eingetaucht sind, wobei die Flüssigkeit eine gute wasserabsorbierende Wirkung aufweist, und daß diese Flüssigkeit mit einer Geschwindigkeit geleert wird, die im Höchstfall der Geschwindigkeit entspricht, die die Kapillarkräfte der Flüssigkeit auf der Oberfläche der Teile ins Gleichgewicht bringt und ermöglicht das Mitnehmen von zu entfernenden und nichthaftenden Partikeln.

## Claims

1. Device for treating flat parts (11) with regular geometry, comprising a chamber (28) comprising side walls, a terminal wall (9), an opening in a front plate (8) opposite said terminal wall, a support means for carrying a plurality of parts (11), a means (15) for introducing treatment fluids, a means (6) for closing said chamber (28), a means (14) for evacuating said fluids, so that they can treat said parts (11) and then empty the chamber (28), characterized in that said means for supporting the parts (11) is fast with the closure means (6) and is constituted by two lateral combs (1) which are mounted to articulate on links (16, 17) allowing them to be moved apart by tipping, in order to allow passage of said parts (11) between the combs, then brought closer, in order that they abut beneath said parts and maintain them in said chamber.

2. Device for treating flat parts (11) according to Claim 1, characterized in that said lateral combs (1) are provided to be driven in rotation.

3. Treatment device according to Claim 2, characterized in that the drive means of each of said combs (1) is constituted by a gear motor (24) outside said chamber, fast with a magnetic coupling placed against said closure means (6) and driving therethrough a plate supporting magnets (25) fixed to the end and in the axis of said comb (1) when the latter is in tilted position for holding said parts (11).

4. Treatment device according to any one of Claims 1 to 3, characteried in that the closure means (6) of said chamber (28) is in sealed abutment against the front plate (8) thanks to the compression of a gasket (27) enabling said chamber to be placed under reduced pressure or overpressure.

5. Method of treating flat parts (11) with regular geometry, using the device according to Claim 1 and comprising the following steps:
- bringing said flat parts (11) stored in their transport basket (2) beneath said chamber (28) which is opened by moving the shell (7) constituting it away from its closure means (6);
- transferring said parts (11) by any transfer means (29) from the basket (2) into the open volume of said chamber (28);
- grasping said parts by tilting said two lateral combs (1) that were previously moved apart, and which engage therebeneath so as to constitute said support means for them, and said transfer means (29) is withdrawn;
- closing said chamber (28) by moving said shell (7) around said parts (11) and their supporting combs (1) until contact and seal against the closure means (6);
- performing all treatment by introducing fluids into the chamber thanks to means (15) and at the end of treatments and after evacuation of the fluids by means (14) and re-opening of the latter, said parts (11) are transferred back into their transport basket (2).

6. Method of treating flat parts (11) of regular geometry according to Claim 5, characterized in that the seal of the shell (7) against said closure means (6) is ensured by any means independent thereof ensuring closure of said chamber (28) by translation of said shell against said closure means.

7. Method of treatment according to either one of Claims 5 and 6, and for flat parts (11) of circular shape, characterized in that, during said treatments by fluids, said lateral support combs (1) are driven in rotation, so that said flat parts (11) rotate on themselves at slow speed in said chamber (28).

8. Method of treatment according to any one of Claims 5 to 7, characterized in that said fluids are projected by nebulizing strips (15) whose orifices lie in the planes separating two contiguous parts (11).

9. Method of treatment according to any one of Claims 5 to 8, characterized in that said liquid fluids are introduced in the chamber (28) until the parts (11) are completely immersed, making it possible to effect at least one sound-vibration treatment thereof.

10. Method of treatment according to any one of Claims 5 to 9, characterized in that, after any treatment by liquid fluids of said parts (11), said chamber (28) is filled, up to total immersion of the parts (11) , with a hot liquid having a high capacity for absorbing water, and said fluid is discharged at a speed at the most equal to that balancing the capillarity tensions of this liquid on the surface of said parts and allowing entrainment of the non-adhering particles to be eliminated.
